Europäisches Patentamt

European Patent Office

Office européen des brevets

(11) Publication number: **0 219 338**
**A2**

## EUROPEAN PATENT APPLICATION

(21) Application number: 86307914.1

(22) Date of filing: 14.10.86

(51) Int. Cl.4: **H 03 D 7/16**
H 03 J 7/02, H 04 N 9/83

(30) Priority: 16.10.85 JP 230608/85

(43) Date of publication of application:
22.04.87 Bulletin 87/17

(84) Designated Contracting States: DE FR GB

(71) Applicant: **VICTOR COMPANY OF JAPAN, LIMITED**
**12, 3-chome, Moriya-Cho Kanagawa-ku**
**Yokohama-Shi Kanagawa-Ken 221 (JP)**

(72) Inventor: **Ozaki, Hidetoshi**
**No. 3-56-9, Kamiishihara**
**Chofu-Shi Tokyo (JP)**

(74) Representative: **Robinson, John Stuart et al**
**MARKS & CLERK 57/60 Lincoln's Inn Fields**
**London WC2A 3LS (GB)**

(54) Digital color signal processing circuit.

(57) A digital color signal processing circuit comprises an automatic phase control loop circuit (13-17, 19) including a first frequency converter (13, 14) which frequency-converts a carrier frequency of an input digital color signal into a first predetermined frequency, a second frequency converter (20) for frequency-converting a carrier frequency of an output signal of the automatic phase control loop circuit into a second predetermined frequency different from the first predetermined frequency, and a control circuit (36, 37, 21) for controlling the second frequency converter based on a control signal obtained from the automatic phase control loop circuit. An output signal of the second frequency converter is outputted as an output signal of the digital color signal processing circuit.

FIG. 2

# 0 219 338

**Description**

## DIGITAL COLOR SIGNAL PROCESSING CIRCUIT

The present invention generally relates to digital color signal processing circuits, and more particularly to a digital color signal processing circuit which frequency-converts a carrier frequency of an input digital color signal into a first predetermined frequency in a first frequency converter and thereafter frequency-converts a carrier frequency of the frequency converted signal into a second predetermined frequency different from the first predetermined frequency.

An example of a conventional digital color signal processing circuit used in a video tape recorder or the like comprises an automatic phase control (APC) loop circuit including a first frequency converter, and a second frequency converter. The APC loop circuit comprises the first frequency converter, a bandpass filter, a phase comparator, a lowpass filter, an adding circuit and a first numeric controlled oscillator (NCO). An NCO is a digital circuit having an output oscillation frequency thereof controlled responsive to a digital value supplied thereto, that is, the NCO is a kind of a digital voltage controlled oscillator. An input digital color signal having a carrier frequency of 3.58 MHz is frequency-converted into a signal having a carrier frequency of 4.5 MHz, for example, in the first frequency converter, and the frequency converted signal is supplied via the bandpass filter to the phase comparator and to the second frequency converter. The phase comparator produces a phase error signal dependent on a phase error of an output signal of the bandpass filter with respect to a reference phase. An unwanted frequency component of the phase error signal is reduced in the lowpass filter, and an output signal of the lowpass filter is added to a first reference data in the adding circuit. An output oscillation frequency of the first NCO is controlled by an output signal of the adding circuit, and an output signal of the first NCO controls the first frequency converter.

The output signal of the bandpass filter is supplied to the second frequency converter as an output of the APC loop circuit, and is frequency-converted into a signal having a carrier frequency of 629 kHz, for example. An output signal of the second frequency converter is outputted as an output of the digital color signal processing circuit. The second frequency converter is controlled by a second NCO an output oscillation frequency of which is controlled depending of a second reference data.

The hue error in the picture becomes large when the regular phase error of the APC loop circuit is large, and for this reason, there is a need to set the D.C. loop gain of the APC loop circuit to a large value so as to reduce the regular phase error. However, when the D.C. loop gain of the APC loop circuit is set to a large value, the frequency band of noise becomes wide. Accordingly, there is a need to set the cutoff frequency of the lowpass filter (loop filter) to a low frequency so as to narrow the frequency band of the noise. But when the cutoff frequency of the lowpass filter is set to a low frequency, the transient response becomes poor. Therefore, the design of the conventional digital color signal processing circuit is such that a point of compromise must be taken between the regular phase error and the transient response. As a result, there are problems in that it is impossible to positively reduce the hue error and the picture quality is easily deteriorated.

Accordingly, it is a general object of the present invention to provide a novel and useful digital color signal processing circuit in which the problems described heretofore are eliminated.

Another and more specific object of the present invention is to provide a digital color signal processing circuit comprising an APC loop circuit including a first frequency converter, a second frequency converter supplied with an output signal of the APC loop circuit, and an NCO for controlling the second frequency converter, where an output oscillation frequency of the NCO is controlled by a control signal obtained from within the APC loop circuit. According to the digital color signal processing circuit of the present invention, it is possible to positively reduce the hue error in an output signal of the second frequency converter which is outputted as an output of the digital color signal processing circuit. In addition, it is possible to narrow the frequency band of the noise because the D.C. loop gain of the APC loop circuit can be set to a small value, and it is possible to set the cutoff frequency of a lowpass filter (loop filter) within the APC loop circuit to a high frequency because the frequency band of the noise can be made narrow. As a result, it is possible to obtain a satisfactory transient response.

Other objects and further features of the present invention will be apparent from the following detailed description when read in conjunction with the accompanying drawings.

FIG.I is a system block diagram showing an example of the conventional digital color signal processing circuit;

FIG.2 is a system block diagram showing a first embodiment of the digital color signal processing circuit according to the present invention;

FIG.3 is a system block diagram showing an embodiment of a phase-to-frequency converter within the block system shown in FIG.2;

FIG.4 is a graph showing a phase versus frequency characteristic of the phase-to-frequency converter;

FIG.5 is a circuit diagram showing an embodiment of a concrete circuit construction of the first embodiment; and

FIG.6 is a system block diagram showing a second embodiment of the digital color signal processing circuit according to the present invention.

FIG.I shows an example of the conventional digital color signal processing circuit. A carrier chrominance signal having a chrominance subcarrier frequency of 3.58 MHz, for example, is applied to an input terminal II

2

and is converted into a digital carrier chrominance signal in an analog-to-digital (A/D) converter 12. The digital carrier chrominance signal is frequency-converted into a signal having a carrier frequency of 4.5 MHz,.for example, in a frequency converter 13. An output frequency converted signal of the frequency converter 13 is supplied to a frequency converter 20 via a bandpass filter 14. An output signal of the bandpass filter 14 is supplied to a phase detector 15 which produces a phase error signal dependent on a phase error of the output signal of the bandpass filter 14 with respect to a reference phase. An unwanted frequency component of the phase error signal is reduced in the lowpass filter 16, and an output signal of the lowpass filter 16 is added to a reference data from a terminal 18 in an adding circuit 17. This reference data is preset so as to determine a free-running frequency of an NCO 19. An output signal of the adding circuit 17 controls an output oscillation frequency of the NCO 19, and the NCO 19 controls the frequency converter 13.

The frequency converter 13, the bandpass filter 14, the phase detector 15, the lowpass filter 16, the adding circuit 17 and the NCO 19 constitute an APC loop circuit.

The output signal of the bandpass filter 14 is supplied to the frequency converter 20 and is frequency-converted into a signal having a low carrier frequency of 629 kHz, for example. The frequency converter 20 is controlled by an NCO 21 an output oscillation frequency of which is controlled depending on a reference data from a terminal 22. This reference data is preset so as to determine a free-running frequency of the NCO 21. An output frequency converted signal of the frequency converter 20 is converted into an analog signal in a digital-to-analog (D/A) converter 23 and is outputted via an output terminal 24.

The hue error becomes large when the regular phase error of the APC loop circuit is large, and for this reason, there is a need to set the D.C. loop gain of the APC loop circuit to a large value so as to reduce the regular phase error. However, when the D.C. loop gain of the APC loop circuit is set to a large value, the frequency band of noise becomes wide. Accordingly, there is a need to set the cutoff frequency of the lowpass filter (loop filter) to a low frequency so as to narrow the frequency band of the noise. But when the cutoff frequency of the lowpass filter is set to a low frequency, the transient response becomes poor. Therefore, the design of the conventional digital color signal processing circuit is such that a point of compromise must be taken between the regular phase error and the transient response. As a result, there are problems in that it is impossible to positively reduce the hue error and the picture quality is easily deteriorated.

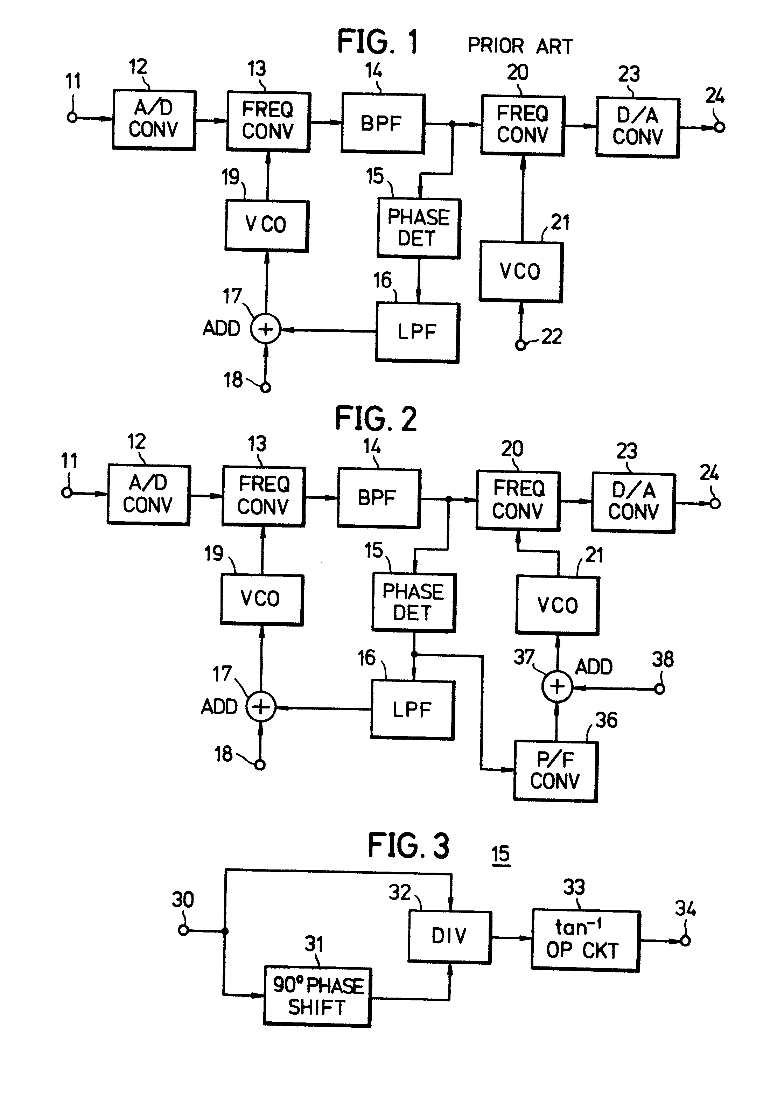

FIG.2 shows a first embodiment of the digital color signal processing circuit according to the present invention. In FIG.2, those parts which are the same as those corresponding parts in FIG.1 are designated by the same reference numerals, and description thereof will be omitted.

The phase detector 15 shown in FIG.2 has a construction shown in FIG.3, for example. In FIG.3, the phase detector 15 comprises a 90° phase shifter 31 which is supplied with the output signal of the bandpass filter 14 via a terminal 30, a dividing circuit 32, and an inverse trigonometric function operation circuit 33. When the frequency, time and phase are respectively denoted by f, t and $\theta$, an input signal $Asin(2\pi ft + \theta)$ of the phase detector 15 received via the terminal 30 is shifted by 90° into a signal $Acos(2\pi ft + \theta)$ in the 90° phase shifter 31. The dividing circuit 32 carries out a division between the signals $Asin(2\pi ft + \theta)$ and $Acos(2\pi ft + \theta)$ and obtains a signal $tan(2\pi ft + \theta)$. This signal $tan(2\pi ft + \theta)$ is supplied to the inverse trigonometric function operation circuit 33 which carries out a $tan^{-1}$ operation, and a phase error signal $2\pi ft + \theta$ is produced from the inverse trigonometric function operation circuit 33 and is outputted via a terminal 34.

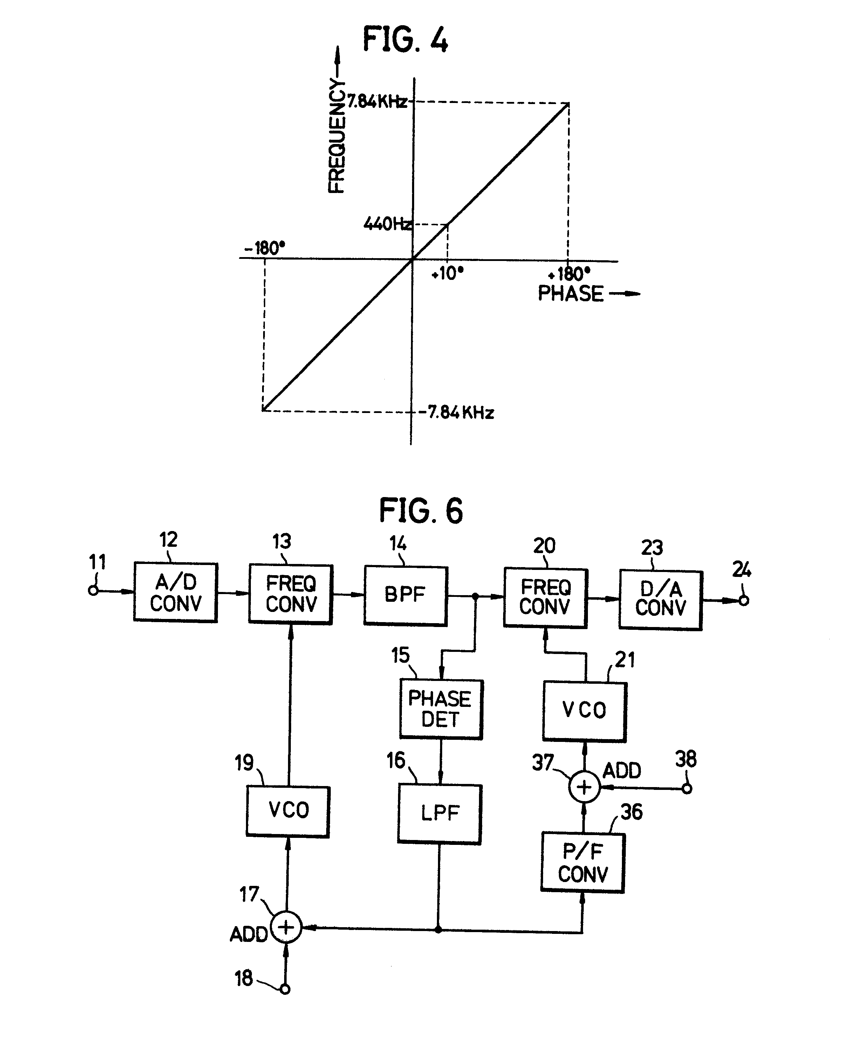

In FIG.2, the output phase error signal of the phase detector 15 is supplied to a phase-to-frequency (P/F) converter 36 wherein the signal is converted into a frequency data dependent on the phase error data. For example, when a phase error data of 10° is obtained from the phase detector 15, the P/F converter 36 produces a frequency data for changing the output oscillation frequency of the NCO 21 to approximately 440 Hz based on a frequency versus phase characteristic (sampling clock signal of 18 MHz and in the case of the NTSC system) shown in FIG.4. For example, the P/F converter 36 comprises a read only memory (ROM) which pre-stores a table for producing data based on the characteristic shown in FIG.4. In the case where the output signal of the phase detector 15 changes linearly, the P/F converter 36 may be constituted by a coefficient multiplier or the like for obtaining the frequency data by multiplying a coefficient to the phase error data.

The output data of the P/F converter 36 is supplied to an adding circuit 37 and is added to a reference data from a terminal 38. This reference data is preset so as to determine a free-running frequency of the NCO 21. An output signal of the adding circuit 37 is supplied to the NCO 21 so as to control the output oscillation frequency thereof. The phase detector 15, the P/F converter 36, the adding circuit 37, the NCO 21 and the frequency converter 20 constitute an open loop APC circuit. Since the frequency conversion is carried out in the frequency converter 20 in response to the output signal of the NCO 21 the output oscillation frequency of which is controlled depending on the phase error signal, the frequency shift in the output signal of the digital color signal processing circuit (output signal of the frequency converter 20) shown in FIG.2 is small compared to that of the conventional digital color signal processing circuit shown in FIG.1.

According to the present embodiment, it is possible to positively reduce the hue error because the frequency shift in the output signal of the digital color signal processing circuit can be made small. In addition, the frequency band of the noise can be made narrow since the D.C. loop gain of the APC loop circuit can be set to a small value. Furthermore, it is possible to set the cutoff frequency of the lowpass filter (loop filter) 16 to a low frequency because the frequency band of the noise can be made narrow, and it is accordingly possible to obtain a satisfactory transient response.

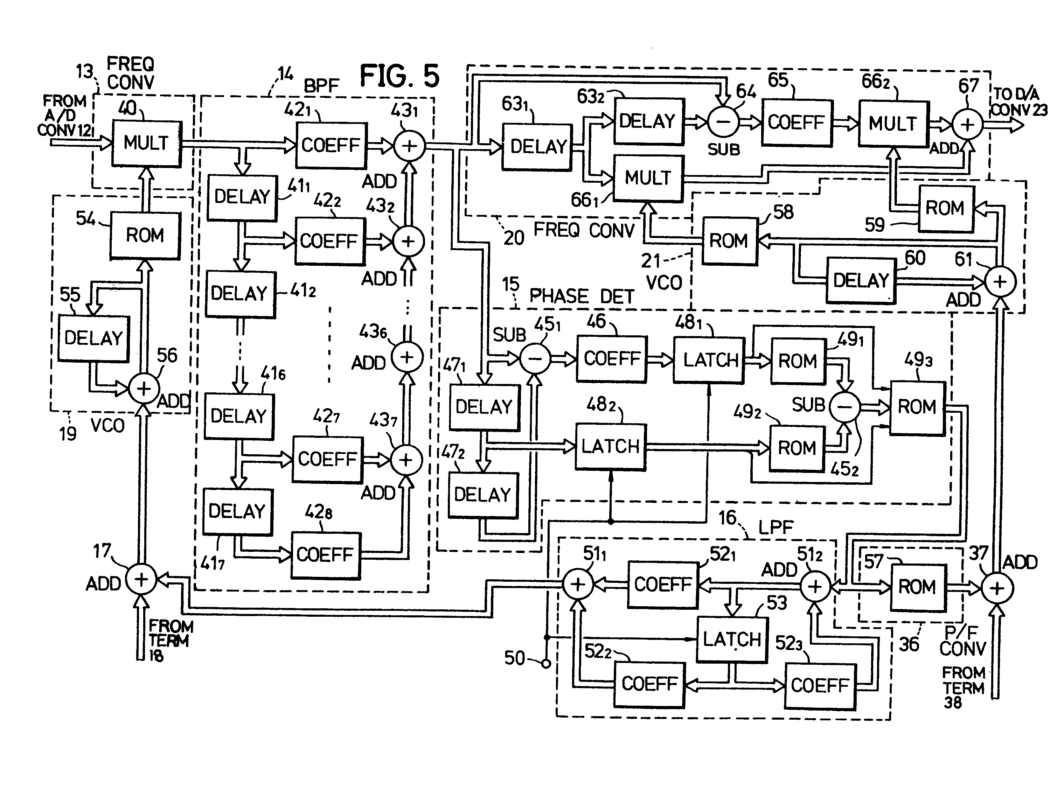

FIG.5 shows an embodiment of the concrete circuit construction of the first embodiment. For example, an 8-bit output digital signal of the A/D converter 12 is supplied to a multiplier 40 constituting the frequency

converter I3. When it is assumed that a signal $A\cos\omega_a t$ is obtained from the A/D converter I2 and a signal $\cos\omega_a't$ is obtained from the NCO I9, the multiplier 40 supplies a signal $(A/2)[\cos(\omega_a+\omega_a')t+\cos(\omega_a-\omega_a')t]$ to the bandpass filter I4. The bandpass filter I4 is constituted by a transversal filter comprising one clock period delay circuits $4I_1$ through $4I_7$, coefficient multipliers $42_1$ through $42_8$ and adders $43_1$ through $43_7$ which are connected as shown.

The phase detector I5 which is supplied with the output signal of the bandpass filter I4 comprises subtracting circuits $45_1$ and $45_2$, a coefficient multiplier 46, one clock period delay circuits $47_1$ and $47_2$, latch circuits $48_1$ and $48_2$ and ROMs $49_1$ through $49_3$. The delay circuits $47_1$ and $47_2$, the subtracting circuit $45_1$ and the coefficient multiplier 46 constitute a transversal filter which substantially operates as the 90° phase shifter 3I shown in FIG.3. Accordingly, the output signal of the delay circuit $47_1$ and the output signal of the coefficient multiplier 46 differ in phase by 90°. When an impulse response h(n) of a finite impulse response (FIR) filter satisfies an asymmetrical condition h(n) = -h(N-n) where n = 0, I, 2, ..., N, the frequency characteristic of the FIR filter can be described by the following equations for odd and even values of N, and a linear phase filter having a linear phase characteristic is obtained.

$$H(e^{j\omega})=[2\sum_{k=0}^{\frac{N}{2}-1} h(k)\sin(N/2-k)\omega]e^{-jN\omega/2-j\pi/2}$$
$$(N:even)$$

$$H(e^{j\omega})=[2\sum_{k=0}^{(N-1)/2} h(k)\sin((N-1)/2-k)\omega]e^{-j(N-1)\omega/2-j\pi/2}$$
$$(N:odd)$$

The latch circuits $48_1$ and $48_2$ are provided to respectively latch input data thereof responsive to a latch clock signal (burst gate pulse) from a terminal 50 so as obtain a color burst signal. The ROMs $49_1$ and $49_2$ respectively pre-store a logarithmic table for obtaining $\log|xI|$ when an input data thereof is assumed to be xI. The ROM $49_3$ pre-stores a table for obtaining $\tan^{-1}[\exp(x2)]$ when an input data thereof is assumed to be x2. When it is assumed that a signal $A\sin\omega$ is obtained from the delay circuit $47_1$, a signal $\cos\omega$ is obtained from the coefficient multiplier 46. When the logarithmic values of these output signals of the delay circuit $47_1$ and the coefficient multiplier 46 are obtained in the ROMs $49_1$ and $49_2$ and are thereafter subjected to a subtraction in the subtracting circuit $45_2$ to obtain a subtracted result, an exponential value of the subtracted result is obtained as $A\sin\theta/A\cos\theta = \tan\theta$. Accordingly, when the $\tan^{-1}$ of this exponential value of the subtracted result is obtained, it is possible to obtain the phase $\theta$ of the output signal of the delay circuit $47_1$. However, since the ROMs $49_1$ and $49_2$ respectively obtain the logarithmic value of an absolute value, the phase $\theta$ becomes $0 \leq \theta \leq \pi/2$. Hence, each code bit of the output signals of the latch circuits $48_1$ and $48_2$ is supplied to the ROM $49_3$ so that it is possible to obtain the phase $\theta$ of $-\pi \leq \theta \leq \pi$.

For example, a 20-bit output signal of the phase detector I5 is supplied to the lowpass filter I6 which is constituted by a standard type digital filter comprising adders $5I_1$ and $5I_2$, coefficient multipliers $52_1$ through $52_3$ and a latch circuit 53 which are connected as shown. The output signal is the lowpass filter I6 is added to the reference data from the terminal I8 in the adding circuit I7, and the added signal is supplied to the NCO I9. The NCO I9 comprises a ROM 54, a one clock period delay circuit 55 and an adder 56. Since a constant value y is added to the signal supplied to the adder 56 from the adding circuit I7 for every one clock period, an overflow occurs every time the added value exceeds a maximum value determined by the number of bits of the output signal of the adder 56. In other words, the overflow occurs with a constant period. Accordingly, when the ROM 54 pre-stores a table of a cosine wave or a sine wave and an access is made to the table by using the output signal of the adder 56 as an address, it is possible to read out from the ROM 54 a continuous cosine wave or sine wave.

The P/F converter 36 which is supplied with the output signal of the phase detector I5 comprises a ROM 57 which is designed to produce data based on the characteristic shown in FIG.4. The output signal of the P/F converter 36 is added to the reference data from the terminal 38, and the added signal is supplied to the NCO 2I. The NCO 2I comprises a ROM 58 which pre-stores a table of a cosine wave, a ROM 59 which pre-stores a table of a sine wave, a one clock period delay circuit 60 and an adder 6I.

The frequency converter 20 comprises one clock period delay circuits $63_1$ and $63_2$, a subtracting circuit 64, a coefficient multiplier 65, multipliers $66_1$ and $66_2$ and an adder 67 which are connected as shown. The data read out from the ROM 58 is supplied to the multiplier $66_1$, and the data read out from the ROM 59 is supplied to the multiplier $66_2$. When it is assumed that a signal $A\sin\omega_b t$ is obtained from the coefficient multiplier 65, a signal $A\cos\omega_b t$ which differs inphase by 90° is obtained from the delay circuit $63_1$. Accordingly, when signals $\cos\omega_b't$ and $\sin\omega_b't$ are respectively obtained from the ROMs 58 and 59, an output signal described by the following equation is obtained from the multiplier $66_1$.

$A\sin\omega_b t \bullet \sin\omega_b't = -(A/2)[\cos(\omega_b+\omega_b')t-\cos(\omega_b-\omega_b')t]$ Hence, an output signal described by the following equation is obtained from the multiplier $66_2$.

$A\cos\omega_b t \bullet \cos\omega_b't = (A/2)[\cos(\omega_b+\omega_b')t+\cos(\omega_b-\omega_b')t]$ Therefore, a signal $A\cos(\omega_b-\omega_b')t$ described by 8 bits, for example, is obtained from the adder 67. and the frequency conversion from the frequency $\omega_b t$ to the frequency $\omega_b t-\omega_b't$ is carried out.

FIG.6 shows a second embodiment of the digital color signal processing circuit according to the present

4

invention. In FIG.6, those parts which are the same as those corresponding parts in FIG.2 are designated by the same reference numerals, and description thereof will be omitted. In the present embodiment, the output signal of the lowpass filter 16 is supplied to the P/F converter 36 instead of the output signal of the phase detector 15. The basic operation and effects of the present embodiment are similar to those of the first embodiment described before.

It is possible to constitute the P/F converter 36 and the adding circuit 37 by a ROM which pre-stores a function table.

In addition, the color signal applied to the input terminal 11 is not limited to that of the embodiments. For example, a frequency converted carrier chrominance signal which has been frequency-converted into a low frequency band may be applied to the input terminal 11, and in this case, a carrier chrominance signal may be obtained from the output terminal 24.

Further, the present invention is not limited to these embodiments, but various variations and modifications may be made without departing from the scope of the present invention.

## Claims

1. A digital color signal processing circuit comprising an automatic phase control loop circuit (13-17, 19) including a first frequency converter (13, 14) which frequency-converts a carrier frequency of an input digital color signal into a first predetermined frequency; and a second frequency converter (20) for frequency-converting a carrier frequency of an output signal of said automatic phase control loop circuit into a second predetermined frequency different from said first predetermined frequency, characterized in that there is provided control means (36, 37, 21) for controlling said second frequency converter (20) based on a control signal obtained from said automatic phase control loop circuit (13-17, 19), said second frequency converter outputting an output signal thereof as an output signal of the digital color signal processing circuit.

2. A digital color signal processing circuit as claimed in claim 1, characterized in that said automatic phase control loop circuit (13-17, 19) comprises a phase detector (15) for producing a phase error signal dependent on a phase error between an output signal of said first frequency converter (13, 14) and a predetermined reference phase, and a first numeric controlled oscillator (19) having an output oscillation frequency thereof controlled responsive to said phase error signal for controlling said first frequency converter, said control means (36, 37, 21) controlling said second frequency converter based on said phase error signal.

3. A digital color signal processing circuit as claimed in claim 2, characterized in that said control means (36, 27, 21) comprises a phase-to-frequency converter (36) supplied with said phase error signal for producing a signal having a frequency dependent on a phase of said phase error signal, an adding circuit (37) for adding the output signal of said phase-to-frequency converter and a reference data, and a second numeric controlled oscillator (21) having an output oscillation frequency thereof controlled responsive to an output signal of said adding circuit for controlling said second frequency converter, said reference data being preset so as to determine a free-running frequency of said second numeric controlled oscillator.

4. A digital color signal processing circuit as claimed in claim 3, characterized in that said phase-to-frequency converter (36) comprises a read only memory (57) which pre-stores a function table.

5. A digital color signal processing circuit as claimed in claim 1, characterized in that said automatic phase control loop circuit (13-17, 19) comprises a phase detector (15) for producing a phase error signal dependent on a phase error between an output signal of said first frequency converter and a predetermined reference phase, a lowpass filter (16) for reducing an unwanted frequency component of the output signal of said phase detector, and a first numeric controlled oscillator (19) having an output oscillation frequency thereof controlled responsive to an output signal of said lowpass filter for controlling said first frequency converter, said control means (36, 37, 21) controlling said second frequency converter based on the output signal of said lowpass filter.

6. A digital color signal processing circuit as claimed in claim 5, characterized in that said control means (36, 37, 21) comprises a phase-to-frequency converter (36) supplied with the output signal of said lowpass filter for producing a signal having a frequency dependent on a phase of the output signal of said lowpass filter, an adding circuit (37) for adding the output signal of said phase-to-frequency converter and a reference data, and a second numeric controlled oscillator (21) having an output oscillation frequency thereof controlled responsive to an output signal of said adding circuit for controlling said second frequency converter, said reference data being preset so as to determine a free-running frequency of said second numeric controlled oscillator.

7. A digital color signal processing circuit as claimed in claim 6, characterized in that said phase-to-frequency converter (36) comprises a read only memory (57) which pre-stores a function table.

8. A digital color signal processing circuit as claimed in claim 1, characterized in that said input digital color signal is a digital carrier chrominance signal, and the output signal of said second frequency converter is a digital frequency converted color signal which has been frequency-converted into a low

5

frequency band.

9. A digital color signal processing circuit as claimed in claim I, characterized in that said input digital color signal is a digital frequency converted color signal which has been frequency-converted into a low frequency band, and the output signal of said second frequency converter is a digital carrier chrominance signal.

0219338

FIG. 1

PRIOR ART

FIG. 2

FIG. 3

# FIG. 4

# FIG. 6

FIG. 5